# EUROPEAN PATENT APPLICATION

(11) **EP 4 811 567 A1**
(43) Date of publication of application: **23.09.2026**
(21) Application number: 24890821.2
(22) Date of filing: 15.11.2024
(51) Int. Cl.: H01S 3/13, H01S 3/131, G06F 17/10

(54) **LASER OUTPUT POWER ADJUSTMENT METHOD, APPARATUS AND SYSTEM, COMPUTER DEVICE, AND MEDIUM**

(30) Priority: 17.11.2023 CN 202311537341
(71) Applicant: Shanghai Raykeen Laser Technology Co., Ltd., Shanghai 200120 (CN)
(72) Inventor: LI, Zhiyu, Shanghai 200120 (CN); LU, Xiaowang, Shanghai 200120 (CN); CAI, Ziyuan, Shanghai 200120 (CN)
(74) Representative: Casalonga
(86) International application number: PCT/CN2024/132333
(87) International publication number: WO 2025/103469

(57) **Abstract**

The present application relates to a laser output power adjustment method, apparatus and system, a computer device, and a storage medium. The laser output power adjustment method comprises: acquiring actual output power data of a laser; performing Kalman filtering processing on the actual output power data to obtain power estimated data; acquiring temperature data of the laser, and on the basis of the temperature data, determining whether the current temperature of the laser is within a preset temperature range; in response to the current temperature being within the preset temperature range, performing first-order inertial filtering processing on the basis of the power estimated data to obtain power filtering data, and on the basis of the power filtering data, determining target output power data; and on the basis of the target output power data, adjusting the actual output power of the laser.

## Description

### Cross-Reference to Related Applications

This application claims priority of the Chinese patent application filed with the China National Intellectual Property Administration on November 17, 2023, with the application number 2023115373418 and the title "A laser output power adjustment method, apparatus and system, a computer device, and a storage medium", the entire contents of which are incorporated herein by reference.

### Technical Field

The present application mainly relates to a laser output power adjustment method, apparatus and system, a computer device, and a storage medium

### Background

With the development of laser technology, it has been widely applied in the medical field, giving rise to laser devices used in medical scenarios, such as holmium lasers and the like.

However, the power parameters of conventional laser devices are fixed values, lacking anti-interference capability against differential influences under different working environments. In addition, the longer the laser emission time, the higher the power, the greater the heat generated by the laser and the higher the temperature, which in turn leads to unstable output power.

### Summary

According to the embodiments of the application, first aspect provides a laser output power adjustment method, comprising:
acquiring an actual output power data of a laser;
performing Kalman filtering processing on the actual output power data, obtaining an power estimated data;
acquiring a temperature data of the laser, and determining whether a current temperature of the laser is within a preset temperature range according to the temperature data,;
in response to the current temperature within the preset temperature range, performing a first-order inertial filtering processing according to the power estimated data to obtain a power filtering data, and determining a target output power data according to the power filtering data; and
adjusting an actual output power of the laser according to the target output power data.

In some embodiments, the method further comprises:
in response to the current temperature not within the preset temperature range, acquiring an initial output power data of a current gear position of the laser; and
taking the initial output power data as the target output power data.

In some embodiments, before determining whether a current temperature of the laser is within a preset temperature range, the method further comprises:
determining whether a determined target output power of the laser exists at a current gear position; and
in response to that the determined target output power of the laser does not exist at the current gear position, proceeding to the step of determining whether a current temperature of the laser is within a preset temperature range.

In some embodiments, performing Kalman filtering processing on the actual output power data, obtaining an power estimated data comprises:
collecting multiple actual output power values of the laser within a preset time period as one set of the actual output power data;
performing Kalman filtering processing on the multiple actual output power values respectively, obtaining multiple power estimated values corresponding respectively to the actual output power values; wherein a formula for the Kalman filtering processing is as follows: $X \left(k\right) = A ∗ X \left(k-1\right) + B ∗ U \left(k\right) + W \left(k\right)$
wherein, *X*(*k*) denotes an power estimated data after k times Kalman filtering processing; *A* denotes a state transition matrix; *X*(*k* - 1) denotes the power estimated data after (k-1) times Kalman filtering processing; *B* denotes a control matrix; *U*(*k*) denotes an error data; *W*(*k*) denotes a process noise data generated during processing; *X*(0) is an actual output power value of an initially input; *k* denotes a number of Kalman filtering processing; and
conducting an average calculation after removing outliers from the multiple power estimated values, obtaining an average estimated power value as the power estimated data.

In some embodiments, a formula of performing a first-order inertial filtering processing to the power estimated data comprises: $Y \left(n\right) = α ∗ X \left(n\right) + \left(1-α\right) ∗ Y \left(n-1\right)$ wherein, *Y*(*n*) denotes a power filtering data obtained after a n times first-order inertial filtering processing; *X*(*n*) denotes the power estimated data input before the n times first-order inertial filtering processing; *Y*(*n* - 1) denotes a power filtering data obtained after (n-1) times first-order inertial filtering processing; *α* denotes a preset weight constant, wherein a range of *α* is (0, 1), and n is a positive integer.

In some embodiments, adjusting an actual output power of the laser according to the target output power data comprises:
calculating a membership degree according to the target output power data and a preset fuzzy control rule;
calculating corresponding voltage control data according to the preset fuzzy control rule and the membership degree; and
controlling a laser power supply of the laser according to the voltage control data to supply a voltage corresponding to the voltage control data to the laser, so as to adjust an output power of the laser matching the voltage.

According to the embodiments of the application, second aspect provides a laser output power adjustment apparatus, the apparatus comprises a main control module, a power feedback module and a temperature detection module, the main control module comprising an optical power control unit and an optical power output unit; wherein,
one end of the power feedback module connects to the optical power control unit via a bus, and the other end of the power feedback module is configured to connect the laser, the optical power output unit is configured to establish communication with the laser, one end of the temperature detection module connecting to the optical power control unit, and the other end of the temperature detection module is configured to connect the laser;
the power feedback module, configured to acquire an actual output power data of a laser, and transmit the actual output power data to the optical power control unit;
the temperature detection module, configured to acquire a temperature data of the laser, and transmit the temperature data to the optical power control unit;
the optical power control unit, configured to perform Kalman filtering processing on the actual output power data, obtaining an power estimated data; acquiring the temperature data of the laser, and, determining whether a current temperature of the laser is within the preset temperature range according to the temperature data; in response to the current temperature within the preset temperature range, performing a first-order inertial filtering processing according to the power estimated data to obtain a power filtering data, and determining a target output power data according to a power filtering data; and
the optical power output unit, configured to adjust an actual output power of the laser according to the target output power data.

According to the embodiments of the application, third aspect provides a laser output power adjustment system, comprising a laser, a laser power supply, a cooling device, and the laser output power adjustment apparatus according to the second aspect;
wherein, one end of the cooling device connects to the laser, and the other end of the cooling device connects to the temperature detection module; the optical power output unit establishes communication with the laser power supply, and the laser power supply is electrically connected to the laser;
a water return port of the cooling device is provided with a temperature sensor for temperature monitoring;
the temperature detection module is configured to collect voltage signals at both ends of the temperature sensor, transmit the voltage signals after amplification processing through an operational amplifier to a single-chip microcomputer for temperature calculation, and transmit the calculated temperature data to the optical power control unit; and
the power feedback module is configured to collect a real-time current data of a laser diode of the laser, after performing independent calculation on each optical pulse signal within a preset unit time according to the real-time current data, obtaining an average power data within the preset unit time as the actual output power data of the laser, and transmit the actual output power data to the optical power control unit.

According to the embodiments of the application, fourth aspect provides a computer device, comprising a memory, a processor and a computer-readable instruction stored in the memory and executable on the processor, the processor implements the steps of the method according to the first aspect when executing the computer-readable instruction.

According to the embodiments of the application, fifth aspect provides a non-volatile computer-readable storage medium having a computer-readable instruction stored thereon, characterized in that, when the computer-readable instruction is executed by a processor, the steps of the method according to the first aspect are implemented.

The details of one or more embodiments of the present application are set forth in the drawings and the description below. Other features and advantages of the present application will be apparent from the specification, the drawings and the claims.

### Brief Description of the Drawings

To more clearly illustrate the technical solutions in the embodiments of the present application, the drawings required for the embodiments are briefly introduced below, obviously, the drawings described below merely show some embodiments of the present application, and those of ordinary skill in the art can derive other drawings from these drawings without creative efforts.
Fig. 1 is a schematic structural diagram of a laser output power adjustment apparatus in some embodiments;
Fig. 2 is a schematic structural diagram of a laser output power adjustment system in some embodiments;
Fig. 3 is a schematic flowchart of a laser output power adjustment method in some embodiments;
Fig. 4 is a schematic flowchart of a laser output power adjustment method in other embodiments;
Fig. 5 is an internal structural diagram of a computer device in some embodiments.

### Preferred Embodiment of the Present Disclosure

To make the objectives, technical solutions and advantages of the present application clearer, the present application will be described in further details below with reference to the drawings and embodiments. It should be understood that the specific embodiments described herein are merely used to explain the present application and are not intended to limit the present application

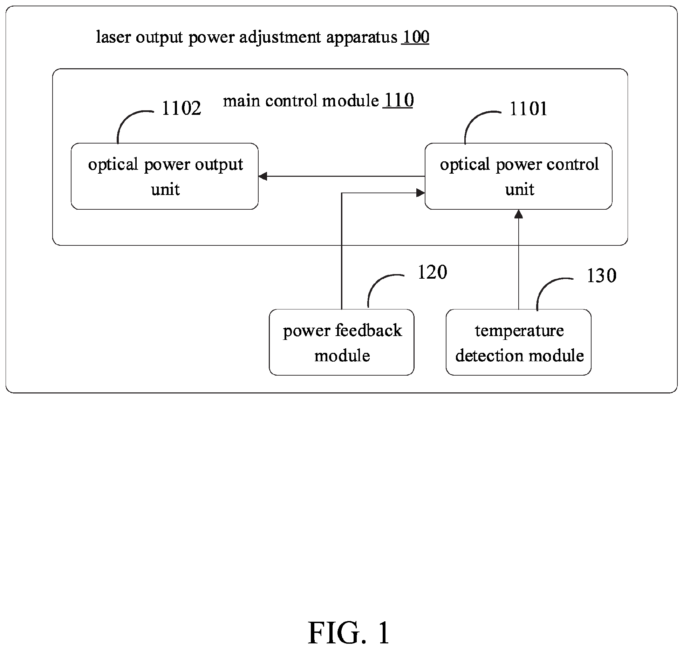

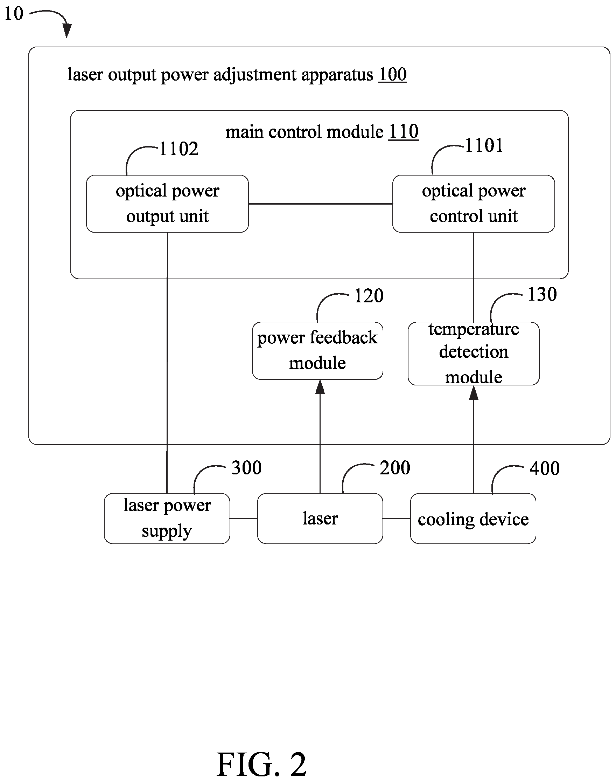

In some embodiments, reference is made to Fig. 1 and Fig. 2. Fig. 1 is a schematic structural diagram of a laser output power adjustment apparatus, and Fig. 2 is a schematic structural diagram of a laser output power adjustment system.

Wherein, referring to Fig. 1, the laser output power adjustment apparatus 100 includes a main control module 110, a power feedback module 120 and a temperature detection module 130. The main control module 110 includes an optical power control unit 1101 and an optical power output unit 1102; wherein,
specifically, one end of the power feedback module 120 connects to the optical power control unit 1101 via a bus, and the other end of the power feedback module 120 is configured to connect the laser 200 (refer to Fig. 2), the optical power output unit 1102 is configured to establish communication with the laser power supply, one end of the temperature detection module 130 connects to the optical power control unit 1101, and the other end of the temperature detection module 130 is configured to connect the laser 200;
the power feedback module 120, configured to acquire an actual output power data of a laser 200, and transmit the actual output power data to the optical power control unit 1101;
the temperature detection module 130, configured to acquire a temperature data of the laser 200, and transmit the temperature data to the optical power control unit;
the optical power control unit 1101, configured to perform Kalman filtering processing on the actual output power data, obtaining an power estimated data; acquiring the temperature data of the laser, and, determining whether a current temperature of the laser is within the preset temperature range according to the temperature data; in response to the current temperature within the preset temperature range, performing a first-order inertial filtering processing according to the power estimated data to obtain a power filtering data, and determining a target output power data according to a power filtering data;
the optical power output unit 1102, configured to adjust an actual output power of the laser 140 according to the target output power data.

Each module in the above laser output power adjustment apparatus may be implemented entirely or partially by software, hardware or a combination thereof. Each of the foregoing modules may be embedded in or independent of the processor of a computer device in a hardware form, or stored in the memory of the computer device in a software form, so that the processor can invoke and execute the operations corresponding to each module.

In some embodiments, refer to Fig. 2, the application further provides a laser output power adjustment system 10, the laser output power adjustment system includes the above-mentioned laser output power adjustment apparatus 100, a laser 200, a laser power supply 300 and a cooling device 400; wherein,
one end of the cooling device 400 connects to the laser 200, and the other end of the cooling device connects to the temperature detection module 130; the optical power output unit 1102 establishes communication with the laser power supply 300 and connects to the optical power control unit 1101, and the laser power supply 300 is electrically connected to the laser 200.

In some embodiments, a water return port of the cooling device 400 can provide a temperature sensor for temperature monitoring, wherein, the cooling device 400 may be equipment used for cooling the laser, such as a chiller; the temperature sensor can be an NTC (Negative Temperature Coefficient) thermistor or the like.

Exemplarily, the water return port of the cooling device may be configured with an open temperature detection port, and an NTC thermistor matching the size of the temperature detection port can be installed at the temperature detection port. When the water temperature in the cooling device changes, the resistance value of the NTC thermistor will change correspondingly. Therefore, the voltage signal of the divided voltage applied to the NTC thermistor can be collected by acquiring the resistance value of the variable NTC thermistor and the resistance value of another fixed resistor, further, the collected voltage signal can be amplified by an operational amplifier and then transmitted to a single-chip microcomputer for temperature calculation to obtain the corresponding current water temperature, so as to estimate the current temperature data of the laser.

Exemplarily, the power feedback module can perform calculation by collecting real-time current data of the laser diode in the laser, when the laser diode is irradiated with light of a corresponding wavelength, its internal current changes linearly with the linear output power of light, and thus it can be used as a calculation medium. The power feedback module may separately calculate each optical pulse signal within a preset unit time according to the real-time current data, obtaining average power data within the preset unit time as the actual output power data of the laser, and transmitting the actual output power data to the optical power control unit.

More specifically, the power feedback module 120 may transmit the calculated actual output power data of the laser to the main control module 110 through CAN communication; the temperature detection module 130 may transmit the calculated temperature data of the laser to the main control module 110 through CAN communication. After calculating the target power data, the main control module 110 can write the target power data into the digital-to-analog conversion chip via SPI (Serial Peripheral Interface), and output a corresponding voltage value through the optical power output unit 1102 to drive the laser power supply 300, so as to realize the control and adjustment of the output power of the laser 200.

The above laser output power adjustment apparatus and laser output power adjustment system are applicable to scenarios where the actual use environment has a significant impact on the output optical power of the laser (such as occasions with rapid changes in operating temperature), using a dynamic closed-loop system to replace the static open-loop system, which adjusts the output voltage signal in real time and efficiently, effectively reduces fluctuations in output power, and enables accurate, controllable and stable output power.

Hereinafter, the laser output power adjustment method provided by the present application will be described in detail.

The laser output power adjustment method provided by the present application can be applied to the laser output power adjustment apparatus shown in Fig. 1 or the laser output power adjustment system shown in Fig. 2. It should be noted that the apparatus in Fig. 1 and the system in Fig. 2 only serve to illustrate the application scenarios in some embodiments of the method provided by the present application, and shall not be regarded as limitations on the method. The method provided by the present application can also be applied to other adapted scenarios.

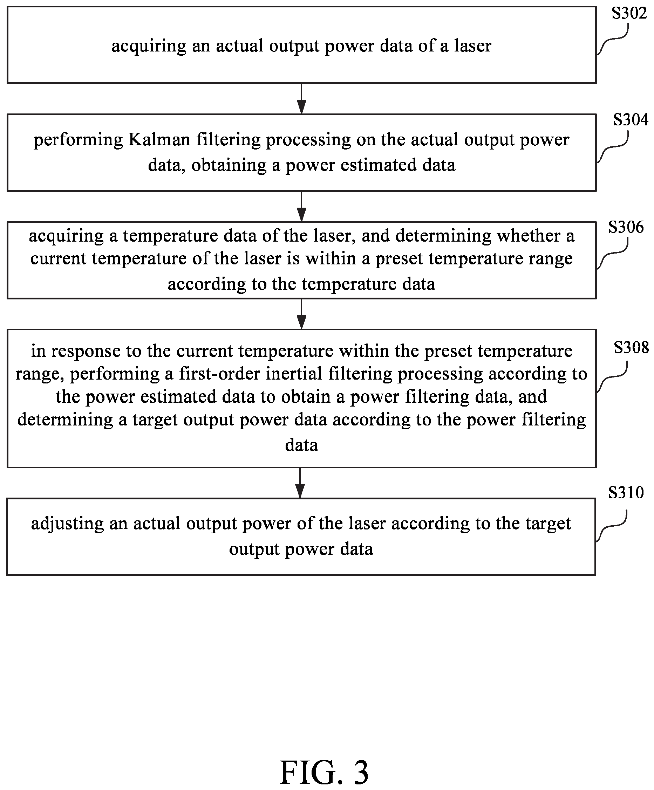

In one embodiment, as shown in Fig. 3, it provides a laser output power adjustment method, taking the application of the method to the main control module in Fig. 1 as an example, the method includes the following steps:
Step 302: acquiring an actual output power data of a laser.

Specifically, the main control module may collect the current actual output power data of the laser periodically or in real time, and may obtain the actual output power data by communicating with a software or hardware unit responsible for collecting and calculating the actual output power of the laser.

In some embodiments, the actual output power data may be collected by the method proposed in the embodiments of the present application, that is, the actual output power data may be acquired through the power feedback unit involved in the present application, in other embodiments, the actual output power data may also be collected by other power detection devices.

In some embodiments, the power feedback module can collect real-time current data of the laser diode in the laser, after performing independent calculation on each optical pulse signal within a preset unit time according to the real-time current data, obtaining an average power data within the preset unit time as the actual output power data of the laser, and transmitting the actual output power data to the optical power control unit.

Step 304: performing Kalman filtering processing on the actual output power data, obtaining an power estimated data.

Specifically, after receiving the actual output power data of the laser, the main control module may perform Kalman filtering processing on the actual output power data, so as to obtain power estimated data filtered from noise interference and other irrelevant information.

Step 306: acquiring a temperature data of the laser, and determining whether a current temperature of the laser is within a preset temperature range according to the temperature data.

Specifically, the main control module may collect the current actual output power data of the laser periodically or in real time, and may obtain the actual output power data by communicating with a software or hardware unit responsible for collecting and calculating the actual output power of the laser. After acquiring the temperature data of the laser, the main control module may determine whether the current operating temperature (current temperature) of the laser falls within a preset temperature range according to the acquired temperature data, wherein the preset temperature range is an optimal temperature range preset for the normal operation of the laser, which can be customized according to different types of lasers.

Exemplarily, it can be set according to the optimal operating temperature of the laser, for example, the preset temperature range may be 18°C±0.5°C.

In some embodiments, the temperature data may be collected by the method proposed in the embodiments of the present application, that is, the temperature data may be acquired through the temperature detection unit involved in the present application, in other embodiments, the temperature data may also be collected by other software or hardware devices for temperature detection. For example, the current temperature data of the laser can be indirectly calculated by collecting the temperature data of the cooling device connected to the laser, or the temperature data of the laser can be directly collected.

In some embodiments, the temperature detection module may collect voltage signals at both ends of the temperature sensor disposed at the water return port of the cooling device, the voltage signals are amplified by an operational amplifier and then transmitted to a single-chip microcomputer for temperature calculation, and by calculating the water temperature of the cooling device, it obtains the temperature data of the laser and transmit the calculated temperature data to the main control module.

Step 308: in response to the current temperature within the preset temperature range, performing a first-order inertial filtering processing according to the power estimated data to obtain a power filtering data, and determining a target output power data according to the power filtering data.

Specifically, if the current temperature of the laser is within the preset temperature range, processing the actual output power data processed by Kalman filtering, namely the power estimated data by a first-order inertial filtering algorithm, thereby, obtaining the output power suitable for the current temperature of the laser through filtering calculation as the target output power. Wherein, the first-order inertial filtering processing can also be called first-order low-pass filter (LPF) processing.

Step 310: adjusting an actual output power of the laser according to the target output power data.

Specifically, after calculating the appropriate target output power data, the main control module can convert the calculated target output power data into corresponding voltage control data, so as to adjust the actual output power of the laser by changing or regulating the supply voltage to the laser.

The above laser output power adjustment method acquires the actual output power data and temperature data of the laser, and performing Kalman filtering and first-order inertial filtering to calculate the target output power data adapted to temperature changes, adjusting the actual output power of the laser in real time and efficiently, effectively reducing output power fluctuations, and achieve precise, controllable and stable output power.

In some embodiments, the method further comprises: in response to the current temperature not within the preset temperature range, acquiring an initial output power data of a current gear position of the laser; taking the initial output power data as the target output power data.

In this embodiment, if it is detected that the current temperature of the laser is not within the preset temperature range, it indicates that the current operating temperature of the laser may be abnormal, and its output power has been significantly affected by temperature, at this time, the initial output power data of the current gear configured in advance can be directly used as the target output power data to adjust the actual output power, that is, the output power parameters of the laser are initialized to achieve maximum power correction under abnormal temperature operating conditions.

In some embodiments, before determining whether a current temperature of the laser is within a preset temperature range, the method further comprises: determining whether a determined target output power of the laser exists at a current gear position; in response to that the determined target output power of the laser does not exist at the current gear position, proceeding to the step of determining whether a current temperature of the laser is within a preset temperature range.

In this embodiment, the determined target output power can be the target output power data correspondingly calculated in the previous cycle for each gear, or it is allowed to manually pre-configure the corresponding target output power for each gear as the determined target output power, therefore, before entering the calculation of closed-loop regulation, it can first check whether a determined target output power exists for the current gear of the laser, if it exists, the actual output power of the laser can be adjusted according to the determined target output power; if not, the process proceeds to the subsequent step of calculating the target output power data. With this embodiment, for each operating gear of the laser, repeated calculations are unnecessary when a determined target output power is already available, thereby improving the efficiency of power regulation.

In some embodiments, performing Kalman filtering processing on the actual output power data, obtaining a power estimated data comprises:
collecting multiple actual output power values of the laser within a preset time period as one set of the actual output power data;
performing Kalman filtering processing on the multiple actual output power values respectively, obtaining multiple power estimated values corresponding respectively to the actual output power values; wherein a formula for the Kalman filtering processing is as follows: $X \left(k\right) = A ∗ X \left(k-1\right) + B ∗ U \left(k\right) + W \left(k\right)$
wherein, *X*(*k*) denotes an power estimated data after k times Kalman filtering processing; *A* denotes a state transition matrix; *X*(*k* - 1) denotes the power estimated data after (k-1) times Kalman filtering processing; *B* denotes a control matrix; *U*(*k*) denotes an error data; *W*(*k*) denotes a process noise data generated during processing; *X*(0) is an actual output power value of an initially input; *k* denotes a number of Kalman filtering processing; and
conducting an average calculation after removing outliers from the multiple power estimated values, obtaining an average estimated power value as the power estimated data.

In the foregoing embodiments, an array may be created to store the collected actual output power values of the laser, and after the array is filled, the values serve as a set of actual output power data for filtering calculation, thereby improving calculation accuracy.

In some embodiments, a formula of performing a first-order inertial filtering processing to the power estimated data comprises: $Y \left(n\right) = α ∗ X \left(n\right) + \left(1-α\right) ∗ Y \left(n-1\right)$
wherein, *Y*(*n*) denotes a power filtering data obtained after a n times first-order inertial filtering processing; *X*(*n*) denotes the power estimated data input before the n times first-order inertial filtering processing; *Y*(*n* - 1) denotes a power filtering data obtained after (n-1) times first-order inertial filtering processing; *α* denotes a preset weight constant, wherein a range of *α* is (0, 1), and n is a positive integer.
wherein, the larger the value of α, the higher the credibility of the collected data; the smaller the value of α, the higher the credibility of the calculated data, and the magnitude of α can be determined according to the actual debugging effect.

In some embodiments, adjusting an actual output power of the laser according to the target output power data comprises: calculating a membership degree according to the target output power data and a preset fuzzy control rule; calculating corresponding voltage control data according to the preset fuzzy control rule and the membership degree; and controlling a laser power supply of the laser according to the voltage control data to supply a voltage corresponding to the voltage control data to the laser, so as to adjust an output power of the laser matching the voltage.

In this embodiment, the calculated or determined target output power is taken as the input value for fuzzy control processing and membership degree calculation, according to preset fuzzy control rules, such as the Mamdani method or Zadeh method, the fuzzy control conclusion is deduced, the maximum value method is adopted for defuzzification to obtain voltage control data, and adjusting the output power by controlling the voltage of the laser power supply supplied to the laser.

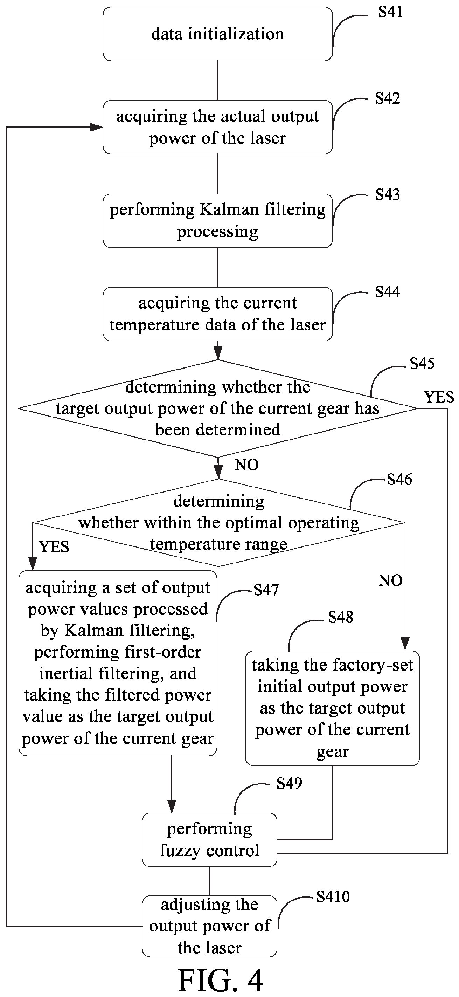

Next, the laser output power adjustment method involved in the present application will be described in further detail in combination with an application example, with reference to Fig. 4, Fig. 4 shows a schematic flowchart of the laser output power adjustment method in some application examples. The specific steps are as follows:
Step S41: data initialization; initializing various parameters of the laser output power regulation system, and setting factory output power, voltage parameters, temperature data and the like;
Step S42: acquiring the actual output power of the laser.
Step S43: performing Kalman filtering processing.
Step S44: acquiring the current temperature data of the laser.
Step S45: determining whether the target output power of the current gear has been determined, if yes, proceeding to Step S49; if not, proceeding to Step S46;
Step S46: determining whether the current temperature is within the optimal operating temperature range, if yes, proceeding to Step S47; if not, proceeding to Step S48;
Step S47: acquiring a set of output power values processed by Kalman filtering, performing first-order inertial filtering, and taking the filtered power value as the target output power of the current gear;
Step S48: taking the factory-set initial output power as the target output power of the current gear;
Step S49: performing fuzzy control according to the target output power;
Step S410: adjusting the output power of the laser.

According to the foregoing various embodiments, the method, apparatus and system involved in the present application are applicable to practical scenarios where ambient conditions have a significant impact on the output optical power of the laser (such as scenarios with rapid changes in operating temperature). A dynamic closed-loop system is adopted to replace the static open-loop system, which adjusts the output voltage signal in real time and efficiently, effectively reducing output power fluctuation, and enabling the output power to be accurate, controllable and stable. It has at least the following advantages:
1) Improved stability: it avoids the non-adjustable error problem existing in open-loop systems and reduces the fluctuation of laser output power caused by changes in the external environment.
2) Faster response speed: adopting closed-loop regulation to increase the response rate and eliminate the cumbersomeness and inefficiency of manual adjustment.
3) Higher accuracy: the laser output power is more precise and controllable, reducing the error relative to the target output power.

It should be understood that although the respective steps in the flowcharts of Fig. 3 to Fig. 4 are displayed sequentially as indicated by the arrows, these steps are not necessarily executed in the order indicated by the arrows. Unless explicitly stated herein, there is no strict restriction on the execution order of these steps, and these steps may be executed in other sequences. Furthermore, at least part of the steps in Fig. 3 to Fig. 4 may include multiple sub-steps or multiple stages, these sub-steps or stages are not necessarily completed at the same time, but can be executed at different moments, the execution order of these sub-steps or stages is not necessarily sequential either, and they can be executed alternately or interleaved with at least part of other steps or the sub-steps and stages thereof.

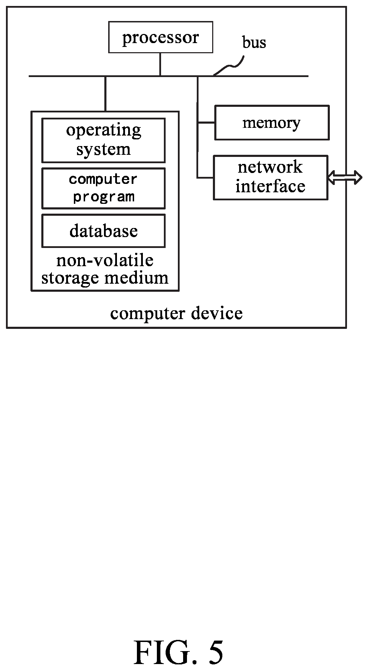

In one embodiment it provides a computer device, the computer device can be a server, and its internal structure diagram is shown in Fig. 5. The computer device includes a processor, a memory, and a network interface connected via a system bus. The processor of the computer device is configured to provide computing and control capabilities. The memory of the computer device includes a non-volatile storage medium and an internal memory. The non-volatile storage medium stores an operating system, computer-readable instructions and a database. The internal memory provides an operating environment for the running of the operating system and computer-readable instructions stored in the non-volatile storage medium. The network interface of the computer device is used for network communication with external terminals. When executed by the processor, the computer-readable instructions implement a laser output power adjustment method.

Those skilled in the art may understand that the structure shown in Fig. 5 is merely a block diagram of part of the structure related to the solution of the present application, and does not limit the computer device to which the solution of the present application is applied. The specific computer device may include more or fewer components than those shown in the figure, combine some components, or adopt a different component arrangement.

In one embodiment it provides a computer device, comprising a memory, a processor and a computer-readable instruction stored in the memory and executable on the processor, the processor implements the following steps when executing the computer-readable instruction: acquiring an actual output power data of a laser; performing Kalman filtering processing on the actual output power data, obtaining an power estimated data; acquiring a temperature data of the laser, and determining whether a current temperature of the laser is within a preset temperature range according to the temperature data; in response to the current temperature within the preset temperature range, performing a first-order inertial filtering processing according to the power estimated data to obtain a power filtering data, and determining a target output power data according to the power filtering data; and adjusting an actual output power of the laser according to the target output power data.

In one embodiment, the processor implements the following steps when executing the computer-readable instruction: in response to the current temperature not within the preset temperature range, acquiring an initial output power data of a current gear position of the laser; and taking the initial output power data as the target output power data.

In one embodiment, the processor implements the following steps when executing the computer-readable instruction: determining whether a determined target output power exists of the laser at a current gear position; and in response to that the determined target output power of the laser does not at the current gear position, proceeding to the step of determining whether a current temperature of the laser is within a preset temperature range.

In one embodiment, the processor implements the following steps when executing the computer-readable instruction: collecting multiple actual output power values of the laser within a preset time period as one set of the actual output power data; performing Kalman filtering processing on the multiple actual output power values respectively, obtaining multiple power estimated values corresponding respectively to the actual output power values; wherein a formula for the Kalman filtering processing is as follows: $X \left(k\right) = A ∗ X \left(k-1\right) + B ∗ U \left(k\right) + W \left(k\right)$ wherein, *X*(*n*) denotes an power estimated data after k times Kalman filtering processing; *A* denotes a state transition matrix; *X*(*k* - 1) denotes the power estimated data after (k-1) times Kalman filtering processing; *B* denotes a control matrix; *U*(*k*) denotes an error data; *W*(*k*) denotes a process noise data generated during processing; *X*(0) is an actual output power value of an initially input; *k* denotes a number of Kalman filtering processing; and conducting an average calculation after removing outliers from the multiple power estimated values, obtaining an average estimated power value as the power estimated data.

In one embodiment, the processor implements the following steps when executing the computer-readable instruction: invoking the formula for first-order inertial filtering to perform first-order inertial filtering on the power prediction data, the formula of a first-order inertial filtering processing comprises: $Y \left(n\right) = α ∗ X \left(n\right) + \left(1-α\right) ∗ Y \left(n-1\right)$ wherein, *Y*(*n*) denotes a power filtering data obtained after a n times first-order inertial filtering processing; *X*(*n*) denotes the power estimated data input before the n times first-order inertial filtering processing; *Y*(*n* - 1) denotes a power filtering data obtained after (n-1) times first-order inertial filtering processing; *α* denotes a preset weight constant, wherein a range of *α* is (0, 1), and n is a positive integer.

In one embodiment, the processor implements the following steps when executing the computer-readable instruction: calculating a membership degree according to the target output power data and a preset fuzzy control rule; calculating corresponding voltage control data according to the preset fuzzy control rule and the membership degree; and controlling a laser power supply of the laser according to the voltage control data to supply a voltage corresponding to the voltage control data to the laser, so as to adjust an output power of the laser matching the voltage.

A person of ordinary skill in the art may understand that all or part of the processes in the methods of the foregoing embodiments can be implemented by instructing relevant hardware through computer-readable instructions, the computer-readable instructions may be stored in a non-volatile computer-readable storage medium, and when executed, the computer-readable instructions implement the processes of the foregoing method embodiments. Among them, any reference to memory, storage, database or other media used in each embodiment provided herein may include non-volatile and/or volatile memory. Non-volatile memory can include Read-Only Memory (ROM), Programmable ROM (PROM), Electrically Programmable ROM (EPROM), Electrically Erasable Programmable ROM (EEPROM), or flash memory. Volatile memory may include Random Access Memory (RAM) or external cache memory. By way of illustration and not limitation, RAM is available in various forms, such as Static RAM (SRAM), Dynamic RAM (DRAM), Synchronous DRAM (SDRAM), Double Data Rate SDRAM (DDR SDRAM), Enhanced SDRAM (ESDRAM), Synchlink DRAM (SLDRAM), Rambus Direct RAM (RDRAM), Direct Rambus DRAM (DRDRAM), and Rambus DRAM (RDRAM).

All technical features of the foregoing embodiments may be combined in any manner, for the sake of concise description, all possible combinations of the technical features in the embodiments have not been exhaustively described, nevertheless, any combination of these technical features that does not contain contradictions shall be deemed to fall within the scope of this specification.

The foregoing embodiments merely illustrate several implementation manners of the present application, although the descriptions are relatively specific and detailed, they shall not be construed as limiting the scope of the invention. It should be noted that those of ordinary skill in the art may make various modifications and improvements without departing from the concept of the present application, all of which shall fall within the protection scope of the present application. Therefore, the protection scope of the present patent shall be subject to the appended claims.

## Claims

1. A laser output power adjustment method, comprising:
acquiring an actual output power data of a laser;
performing Kalman filtering processing on the actual output power data, obtaining an power estimated data;
acquiring a temperature data of the laser, and determining whether a current temperature of the laser is within a preset temperature range according to the temperature data;
in response to the current temperature within the preset temperature range, performing a first-order inertial filtering processing according to the power estimated data to obtain a power filtering data, and determining a target output power data according to the power filtering data; and
adjusting an actual output power of the laser according to the target output power data.

2. The adjustment method according to claim 1, **characterized by** further comprising:
in response to the current temperature not within the preset temperature range, acquiring an initial output power data of a current gear position of the laser; and
taking the initial output power data as the target output power data.

3. The adjustment method according to claim 1, **characterized in that**, before determining whether a current temperature of the laser is within a preset temperature range, the method further comprises:
determining whether a determined target output power of the laser exists at a current gear position; and
in response to that the determined target output power of the laser does not exist at the current gear position, proceeding to the step of determining whether a current temperature of the laser is within a preset temperature range.

4. The adjustment method according to claim 1, **characterized in that**, performing Kalman filtering processing on the actual output power data, obtaining an power estimated data comprises:
collecting multiple actual output power values of the laser within a preset time period as one set of the actual output power data;
performing Kalman filtering processing on the multiple actual output power values respectively, obtaining multiple power estimated values corresponding respectively to the actual output power values; wherein a formula for the Kalman filtering processing is as follows: $X \left(k\right) = A ∗ X \left(k-1\right) + B ∗ U \left(k\right) + W \left(k\right)$
wherein, *X*(*k*) denotes an power estimated data after k times Kalman filtering processing; *A* denotes a state transition matrix; *X*(*k* - 1) denotes the power estimated data after (k-1) times Kalman filtering processing; *B* denotes a control matrix; *U*(*k*) denotes an error data; *W*(*k*) denotes a process noise data generated during processing; *X*(0) is an actual output power value of an initially input; *k* denotes a number of Kalman filtering processing; and
conducting an average calculation after removing outliers from the multiple power estimated values, obtaining an average estimated power value as the power estimated data.

5. The adjustment method according to claim 4, **characterized in that**, a formula of performing a first-order inertial filtering processing to the power estimated data comprises: $Y \left(n\right) = α ∗ X \left(n\right) + \left(1-α\right) ∗ Y \left(n-1\right)$ wherein, *Y*(*n*) denotes a power filtering data obtained after n times first-order inertial filtering processing; *X*(*n*) denotes the power estimated data input before the n times first-order inertial filtering processing; *Y*(*n* - 1) denotes a power filtering data obtained after (n-1) times first-order inertial filtering processing; *α* denotes a preset weight constant, wherein a range of *α* is (0, 1), and n is a positive integer.

6. The adjustment method according to claim 1, **characterized in that**, adjusting an actual output power of the laser according to the target output power data comprises:
calculating a membership degree according to the target output power data and a preset fuzzy control rule;
calculating corresponding voltage control data according to the preset fuzzy control rule and the membership degree; and
controlling a laser power supply of the laser according to the voltage control data to supply a voltage corresponding to the voltage control data to the laser, so as to adjust an output power of the laser matching the voltage.

7. A laser output power adjustment apparatus, **characterized in that**, the apparatus comprises a main control module, a power feedback module and a temperature detection module, the main control module comprising an optical power control unit and an optical power output unit; wherein,
one end of the power feedback module connects to the optical power control unit via a bus, and the other end of the power feedback module is configured to connect the laser, the optical power output unit is configured to establish communication with the laser, one end of the temperature detection module connecting to the optical power control unit, and the other end of the temperature detection module is configured to connect the laser;
the power feedback module, configured to acquire an actual output power data of a laser, and transmit the actual output power data to the optical power control unit;
the temperature detection module, configured to acquire a temperature data of the laser, and transmit the temperature data to the optical power control unit;
the optical power control unit, configured to perform Kalman filtering processing on the actual output power data, obtaining an power estimated data; acquiring the temperature data of the laser, and, determining whether a current temperature of the laser is within the preset temperature range according to the temperature data; in response to the current temperature within the preset temperature range, performing a first-order inertial filtering processing according to the power estimated data to obtain a power filtering data, and determining a target output power data according to a power filtering data; and
the optical power output unit, configured to adjust an actual output power of the laser according to the target output power data.

8. A laser output power adjustment system, **characterized by** comprising a laser, a laser power supply, a cooling device, and the laser output power adjustment apparatus according to claim 7;
wherein, one end of the cooling device connects to the laser, and the other end of the cooling device connects to the temperature detection module; the optical power output unit establishes communication with the laser power supply, and the laser power supply is electrically connected to the laser;
a water return port of the cooling device is provided with a temperature sensor for temperature monitoring;
the temperature detection module is configured to collect voltage signals at both ends of the temperature sensor, transmit the voltage signals after amplification processing through an operational amplifier to a single-chip microcomputer for temperature calculation, and transmit the calculated temperature data to the optical power control unit; and
the power feedback module is configured to collect a real-time current data of a laser diode of the laser, after performing independent calculation on each optical pulse signal within a preset unit time according to the real-time current data, obtaining an average power data within the preset unit time as the actual output power data of the laser, and transmit the actual output power data to the optical power control unit.

9. A computer device, comprising a memory, a processor and a computer-readable instruction stored in the memory and executable on the processor, **characterized in that**, the processor implements the steps of the method as claimed in any one of claims 1 to 7 when executing the computer-readable instruction.

10. A non-volatile computer-readable storage medium having a computer-readable instruction stored thereon, **characterized in that**, when the computer-readable instruction is executed by a processor, the steps of the method as claimed in any one of claims 1 to 7 are implemented.
